# EUROPEAN PATENT APPLICATION

(11) **EP 4 478 411 A1**
(43) Date of publication of application: **18.12.2024**
(21) Application number: 24179545.9
(22) Date of filing: 03.06.2024
(51) Int. Cl.: H01L 25/075, H01L 23/00, H01L 33/38, H01L 33/44, H01L 33/62, H01L 33/40, H01L 33/22, H01L 33/42

(54) **DISPLAY DEVICE AND METHOD OF MANUFACTURING THE SAME**

(30) Priority: 12.06.2023 KR 20230075026
(71) Applicant: LG Display Co., Ltd., Seoul 07336 (KR)
(72) Inventor: Yuseok, Jung, 10845 Paju-si (KR); Kim, Kanghyun, 10845 Paju-si (KR)
(74) Representative: Ter Meer Steinmeister & Partner

(57) **Abstract**

A display device includes a substrate in which a plurality of sub pixels are defined; a pair of low potential power lines are in a sub pixel of the plurality of sub pixels; and a plurality of light emitting diodes that overlap an area between the pair of low potential power lines. Each of the plurality of light emitting diodes includes a first semiconductor layer; an emission layer; a second semiconductor layer; a first insulating film that encloses side surfaces of the first semiconductor layer, the emission layer, and the second semiconductor layer; a side electrode on the first insulating film; and a first electrode that is in contact with a bottom surface of the first semiconductor layer and a lower part of the side electrode.

## Description

### CROSS-REFERENCE TO RELATED APPLICATION

This application claims the priority of Republic of Korea Patent Application No. 1 0-2023-0075026 filed on June 12, 2023, in the Korean Intellectual Property Office.

### BACKGROUND

### Field

The present disclosure relates to a display device and a method of manufacturing the same, and more particularly to, a display device using a light emitting diode (LED) and a method of manufacturing the same.

### Description of the Related Art

As display devices which are used for a monitor of a computer, a television, or a cellular phone, there are an organic light emitting display device (OLED) which is a self-emitting device and a liquid crystal display device (LCD) which requires a separate light source.

An applicable range of the display device is diversified to personal digital assistants as well as monitors of computers and televisions and a display device with a large display area and a reduced volume and weight is being studied.

Further, in recent years, a display device including an LED is attracting attention as a next generation display device. Since the LED is formed of an inorganic material, rather than an organic material, reliability is excellent so that a lifespan thereof is longer than that of the liquid crystal display device or the organic light emitting display device. Further, the LED has a fast-lighting speed, excellent luminous efficiency, and a strong impact resistance so that a stability is excellent and an image having a high luminance may be displayed.

### SUMMARY

An object to be achieved by the present disclosure is to provide a display device which improves a yield of a self-assembly process of a light emitting diode and a method of manufacturing a display device.

Another object to be achieved by the present disclosure is to provide a display device which suppresses a light emitting diode from being adhered to a place other than an opening during a self-assembly and a method of manufacturing a display device.

Still another object to be achieved by the present disclosure is to provide a display device which improves a light extraction efficiency by partially forming a ferromagnetic electrode having a low reflectance in a side portion of the light emitting diode and a method of manufacturing a display device.

Still another object to be achieved by the present disclosure is to provide a display device which improves a light extraction efficiency by forming an electrode having a high reflection efficiency in a lower part of the light emitting diode and a method of manufacturing a display device.

Still another object to be achieved by the present disclosure is to provide a display device which partially forms an ohmic contact electrode in a lower part of the light emitting diode to minimize or at least reduce the lowering of a light extraction efficiency by the ohmic contact electrode and improve a resistance and a method of manufacturing a display device.

Still another object to be achieved by the present disclosure is to provide a display device in which an irregularity structure is formed in a lower portion of the light emitting diode and a manufacturing method of a display device.

Objects of the present disclosure are not limited to the above-mentioned objects, and other objects, which are not mentioned above, can be clearly understood by those skilled in the art from the following descriptions. At least one of the objects is solved by the subject-matter of the independent claims. Refinements and advantageous embodiments are defined by respective dependent claims.

In one embodiment, a display device comprises: a substrate in which a plurality of sub pixels are defined; a pair of low potential power lines in a sub pixel of the plurality of sub pixels, the low potential power lines in the pair are spaced apart from each other; and a plurality of light emitting diodes included in the sub pixel, the plurality of light emitting diodes in the sub pixel overlapping an area between the pair of low potential power lines in the sub pixel, wherein at least one of the plurality of light emitting diodes includes: a first semiconductor layer; an emission layer on the first semiconductor layer; a second semiconductor layer on the emission layer; a first insulating film that encloses a side surface of the first semiconductor layer, a side surface of the emission layer, and a side surface of the second semiconductor layer; a side electrode on the first insulating film and overlapping the side surface of the first semiconductor layer; and a first electrode that is in contact with a bottom surface of the first semiconductor layer and a lower part of the side electrode. Accordingly, the side electrode is partially formed in a side portion of the light emitting diode to minimize or at least reduce the lowering the luminous efficiency due to the side electrode.

In one embodiment, a method of manufacturing a display device comprises: inputting a substrate into a chamber that includes a fluid and a plurality of light emitting diodes, the substrate comprising a pair of low potential power lines that are spaced apart from each other; moving the plurality of light emitting diodes to the substrate using a magnet; and applying a voltage to the pair of low potential power lines and forming an electric field between the pair of low potential power lines, the plurality of light emitting diodes self-assembled on the substrate between the pair of low potential power lines responsive to the electric field, wherein each of the plurality of light emitting diodes includes: a first semiconductor layer; an emission layer on the first semiconductor layer; a second semiconductor layer on the emission layer; a first insulating film that encloses a side surface of the first semiconductor layer, a side surface of the emission layer, and a side surface of the second semiconductor layer; a side electrode on the first insulating film and overlapping the side surface of the first semiconductor layer; and a second insulating film that covers the side electrode and the first insulating film. Accordingly, the second insulating film is formed so that the semiconductor layer of the light emitting diode having a polarity is not stuck to an incorrect position and the yield of the self-assembling process may be improved.

According to a further embodiment, a light emitting diode include: a first semiconductor layer; an emission layer on the first semiconductor layer; a second semiconductor layer on the emission layer; a first insulating film that encloses a side surface of the first semiconductor layer, a side surface of the emission layer, and a side surface of the second semiconductor layer; a side electrode on the first insulating film and overlapping the side surface of the first semiconductor layer; and a first electrode that is in contact with a bottom surface of the first semiconductor layer and a lower part of the side electrode.

According to a further embodiment, a light emitting diode comprises: a first electrode; a first semiconductor layer on the first electrode; a second semiconductor layer on the first semiconductor layer; an emission layer between the first semiconductor layer and the second semiconductor layer, the emission layer configured to emit light; a second electrode on the second semiconductor layer, the second semiconductor layer between the second electrode and the emission layer; and a third electrode on a side surface of the first semiconductor layer such that the third electrode is between an end of the first electrode and the side surface of the first semiconductor layer.

Any one of the embodiments of the present disclosure may comprise one or several of the following optional features:
The first electrode and the side electrode may include different materials.

The side electrode may include a ferromagnetic material.

The first electrode may be a reflection electrode that reflects light more than the side electrode.

The display device may further comprise a reflection layer below the plurality of light emitting diodes. The first electrode may include a transparent conductive material.

The first insulating film may be between the side electrode and the first semiconductor layer. The side electrode may be electrically connected to the first semiconductor layer via the first electrode that is in contact with the bottom surface of the first semiconductor layer.

Each of the plurality of light emitting diodes may further comprise a second electrode on the second semiconductor layer. The first insulating film may cover an edge of the second electrode.

The display device may further comprise an ohmic contact electrode between a portion of the first electrode and a portion of the first semiconductor layer. The ohmic contact electrode may overlap an area between the pair of low potential power lines.

The bottom surface of the first semiconductor layer may include a first part that is in contact with the first electrode and a second part that is in contact with the ohmic contact electrode.

The bottom surface of the first semiconductor layer may include an irregularity structure at a location where the ohmic contact electrode and the first semiconductor layer contact each other. The irregularity structure may comprise a jagged surface.

The bottom surface of the first semiconductor layer may include an irregularity structure at a location that overlaps an area between the pair of low potential power lines. The irregularity structure may comprise a jagged surface.

The side electrode may include a ferromagnetic material and the plurality of light emitting diodes may be moved to the substrate responsive to a magnetic attraction between the magnet and the side electrode of each of the plurality of light emitting diodes.

The method of manufacturing a display device may further comprise: removing the second insulating film of each of the plurality of light emitting diodes after the plurality of light emitting diodes are self-assembled between the pair of low potential power lines; and forming a contact electrode that electrically connects the pair of low potential power lines and the side electrode of each of the plurality of light emitting diodes.

The method of manufacturing a display device may further comprise: disposing a passivation layer between the pair of low potential power lines and the plurality of light emitting diodes; forming a contact hole in the passivation layer; and connecting the contact electrode to at least one of the pair of low potential power lines through the contact hole formed in the passivation layer.

The third electrode may comprise a ferromagnetic material.

The light emitting diode may further comprise: an insulating layer on the side surface of the first semiconductor layer, a side surface of the emission layer, a side surface of the second semiconductor layer, and a side surface of the second electrode such that a portion of the insulating layer is between the third electrode and the side surface of the first semiconductor layer.

The insulating layer may overlap a first portion of an upper surface of the second electrode without overlapping a second portion of the upper surface of the second electrode.

An end of the insulating layer may contact an upper surface of the first electrode.

The first electrode may be reflective.

The first semiconductor layer may comprise an irregularity structure at a portion of a lower surface of the first semiconductor layer. The irregularity structure may include a jagged surface.

The light emitting diode may comprise a fourth electrode between a first portion of the first electrode and a first portion of the first semiconductor layer without being between a second portion of the first electrode and a second portion of the first semiconductor layer.

According to the present disclosure, a transfer process optimization of a light emitting diode is performed to reduce a production energy of the display device.

In one embodiment, a light emitting diode, comprises: a first electrode; a first semiconductor layer on the first electrode; a second semiconductor layer on the first semiconductor layer; an emission layer between the first semiconductor layer and the second semiconductor layer, the emission layer configured to emit light; a second electrode on the second semiconductor layer, the second semiconductor layer between the second electrode and the emission layer; and a third electrode on a side surface of the first semiconductor layer such that the third electrode is between an end of the first electrode and the side surface of the first semiconductor layer.

Other detailed matters of the exemplary embodiments are included in the detailed description and the drawings.

According to the present disclosure, a yield of a self-assembly process of the light emitting diode may be improved.

According to the present disclosure, a side electrode is formed on a first insulating film to protect a semiconductor layer of a light emitting diode when the side electrode and a contact electrode are connected.

According to the present disclosure, a side electrode having a low reflection efficiency is partially formed only in a side portion of the light emitting diode to minimize the lowering of the light extraction efficiency due to the side electrode.

According to the present disclosure, an ohmic contact electrode is partially formed on a lower side of the light emitting diode to improve the resistance and minimize or at least reduce the lowering of the light extraction efficiency due to the ohmic contact electrode.

According to the present disclosure, an irregularity structure is formed below the light emitting diode to improve a light extraction efficiency and reduce power consumption.

The effects of the present disclosure are not limited to the aforementioned effects, and other effects, which are not mentioned above, will be apparently understood to a person having ordinary skill in the art from the following description.

The objects to be achieved by the present disclosure, the means for achieving the objects, and the effects of the present disclosure described above do not specify essential features of the claims, and, thus, the scope of the claims is not limited to the disclosure of the present disclosure.

The effects according to the present disclosure are not limited to the contents exemplified above, and more various effects are included in the present specification.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a schematic diagram of a display device according to an exemplary embodiment of the present disclosure;
FIG. 2A is a partial cross-sectional view of a display device according to an exemplary embodiment of the present disclosure;
FIG. 2B is a perspective view of a tiling display device according to an exemplary embodiment of the present disclosure;
FIG. 3 is an enlarged plan view of an active area of a display device according to an exemplary embodiment of the present disclosure;
FIG. 4 is a cross-sectional view of a sub pixel of a display device according to an exemplary embodiment of the present disclosure;
FIGS. 5A to 5D are cross-sectional views for explaining a method of manufacturing a light emitting diode of a display device according to an exemplary embodiment of the present disclosure;
FIGS. 6A to 6E are cross-sectional views for explaining a method of manufacturing a display device according to an exemplary embodiment of the present disclosure using a self-assembly process;
FIG. 7 is a cross-sectional view of a display device according to an exemplary embodiment of the present disclosure;
FIG. 8 is an enlarged plan view of a sub pixel of a display device according to an exemplary embodiment of the present disclosure;
FIG. 9 is a cross-sectional view of a display device according to still another exemplary embodiment of the present disclosure; and
FIG. 10 is a cross-sectional view of a display device according to still another exemplary embodiment of the present disclosure.

### DETAILED DESCRIPTION

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure.

The shapes, sizes, ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "comprising" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, another layer or another element may be interposed directly on the other element or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, exemplary embodiments of the present disclosure will be described in detail with reference to accompanying drawings.

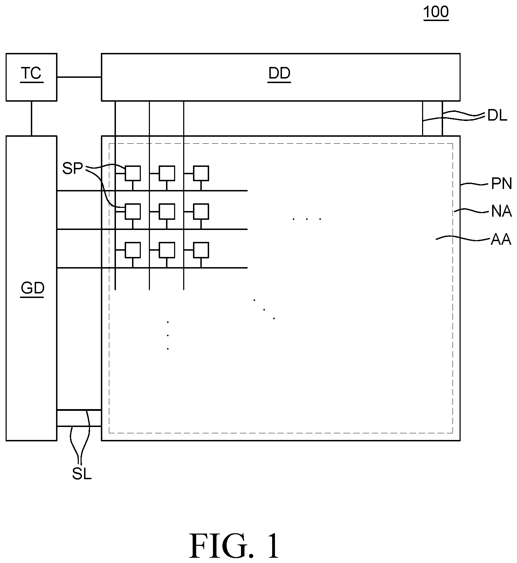

FIG. 1 is a schematic diagram of a display device according to an exemplary embodiment of the present disclosure. In FIG. 1, for the convenience of description, among various components of the display device 100, a display panel PN, a gate driver GD, a data driver DD, and a timing controller TC are illustrated.

Referring to FIG. 1, the display device 100 includes a display panel PN including a plurality of sub pixels SP, a gate driver GD and a data driver DD which supply various signals to the display panel PN, and a timing controller TC which controls the gate driver GD and the data driver DD.

The gate driver GD supplies a plurality of scan signals to a plurality of scan lines SL according to a plurality of gate control signals supplied from the timing controller TC. Even though in FIG. 1, it is illustrated that one gate driver GD is disposed to be spaced apart from one side of the display panel PN, the number of the gate drivers GD and the placement thereof are not limited thereto.

The data driver DD supplies a data voltage to a plurality of data lines DL according to a plurality of data control signals and image data supplied from the timing controller TC. The data driver DD converts the image data into a data voltage using a reference gamma voltage and may supply the converted data voltage to the plurality of data lines DL.

The timing controller TC aligns image data input from the outside to supply the image data to the data driver DD. The timing controller TC may generate a gate control signal and a data control signal using synchronization signals input from the outside, such as a dot clock signal, a data enable signal, and horizontal/vertical synchronization signals. Further, the timing controller TC supplies the generated gate control signal and data control signal to the gate driver GD and the data driver DD, respectively, to control the gate driver GD and the data driver DD.

The display panel PN is a configuration which displays images to the user and includes the plurality of sub pixels SP. In the display panel PN, the plurality of scan lines SL and the plurality of data lines DL intersect each other and the plurality of sub pixels SP may be formed to intersections of the scan lines SL and the data lines DL.

In the display panel PN, an active area AA and a non-active area NA may be defined.

The active area AA is an area in which images are displayed in the display device 100. In the active area AA, a plurality of sub pixels SP which configures a plurality of pixels PX and a pixel circuit for driving the plurality of sub pixels SP may be disposed. The plurality of sub pixels SP are a minimum unit which configures the active area AA and n sub pixels SP form one pixel PX. In each of the plurality of sub pixels SP, a thin film transistor for driving the plurality of light emitting diodes 130 may be disposed. The plurality of light emitting diodes 130 may be defined in different ways depending on the type of the display panel PN. For example, when the display panel PN is an inorganic light emitting display panel PN, the light emitting diode 130 may be a light emitting diode (LED) or a micro light emitting diode (LED).

In the active area AA, a plurality of signal lines which transmits various signals to the plurality of sub pixels SP are disposed. For example, the plurality of signal lines includes a plurality of data lines DL which supply a data voltage to each of the plurality of sub pixels SP and a plurality of scan lines which supply a scan signal to each of the plurality of sub pixels SP. The plurality of scan lines SL extend in one direction in the active area AA to be connected to the plurality of sub pixels SP and the plurality of data lines DL extend in a direction different from the one direction in the active area AA to be connected to the plurality of sub pixels SP. In addition, in the active area AA, a low potential power line VSS and a high potential power line VDD may be further disposed, but are not limited thereto.

The non-active area NA is an area where images are not displayed so that the non-active area NA may be defined as an area extending from the active area AA. In the non-active area NA, a link line which transmits a signal to the sub pixel SP of the active area AA, a pad electrode, or a driving IC, such as a gate driver IC or a data driver IC, may be disposed.

In the meantime, the non-active area NA may be located on a rear surface of the display panel PN, that is, a surface on which the sub pixels SP are not disposed or may be omitted, and is not limited as illustrated in the drawing.

In the meantime, a driver, such as a gate driver GD, a data driver DD, and a timing controller TC, may be connected to the display panel PN in various ways. For example, the gate driver GD may be mounted in the non-active area NA in a gate in panel (GIP) manner or mounted between the plurality of sub pixels SP in the active area AA in a gate in active area (GIA) manner.

For example, the data driver DD and the timing controller TC are formed in separate flexible film and printed circuit board and the display panel PN is electrically connected to the data driver DD and the timing controller TC by bonding the flexible film and printed circuit board to the pad electrode formed in the non-active area NA of the display panel PN.

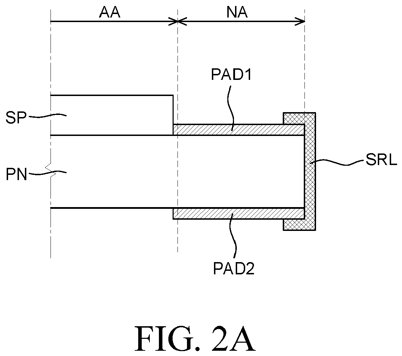

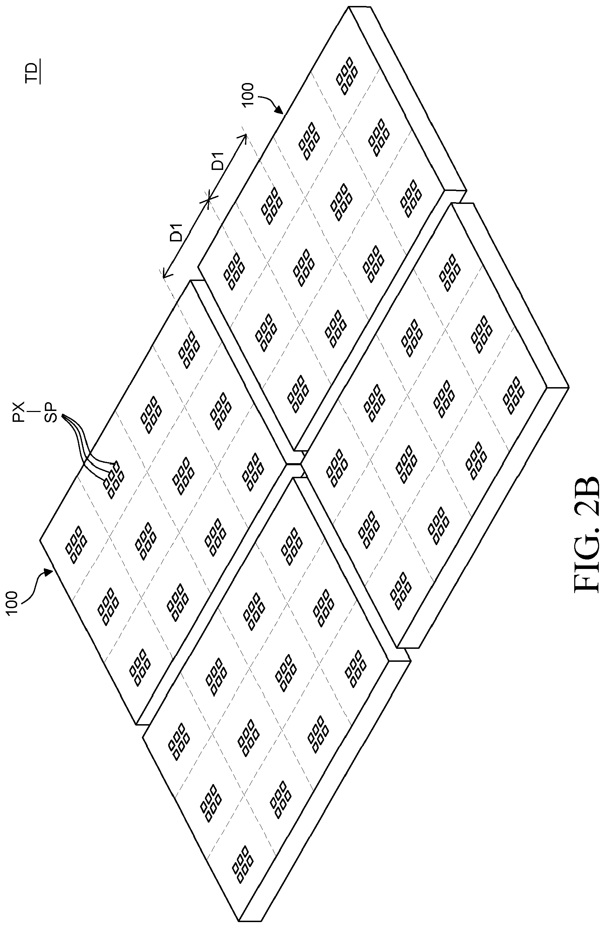

As another example, the gate driver GD is mounted in the active area AA in the GIA manner and a side line SRL which connects the signal line on the front surface of the display panel PN to the pad electrode on a rear surface of the display panel PN is formed to bond the flexible film and the printed circuit board onto a rear surface of the display panel PN. At this time, the non-active area NA on the front surface of the display panel PN may be minimized or at least reduced. Therefore, when the gate driver GD, the data driver DD, and the timing controller TC are connected to the display panel PN as described above, a zero bezel in which there is no bezel may be substantially implemented, which will be described in more detail with reference to FIGS. 2A and 2B.

FIG. 2A is a partial cross-sectional view of a display device according to an exemplary embodiment of the present disclosure. FIG. 2B is a perspective view of a tiling display device according to an exemplary embodiment of the present disclosure.

In the non-active area NA of the display panel PN, a plurality of pad electrodes for transmitting various signals to the plurality of sub pixels SP are disposed. For example, in the non-active area NA of the front surface of the display panel PN, a first pad electrode PAD1 which transmits a signal to the plurality of sub pixels SP is disposed. In the non-active area NA of the rear surface of the display panel PN, a second pad electrode PAD2 which is electrically connected to a driving component such as a flexible film and the printed circuit board is disposed.

In this case, even though it is not illustrated in the drawing, various signal lines connected to the plurality of sub pixels SP, for example, a scan line SL or a data line DL extends from the active area AA to the non-active area NA to be electrically connected to the first pad electrode PAD1.

Further, the side line SRL is disposed along a side surface of the display panel PN. The side line SRL may electrically connect the first pad electrode PAD1 on the front surface of the display panel PN and the second pad electrode PAD2 on the rear surface of the display panel PN. Therefore, a signal from a driving component on the rear surface of the display panel PN may be transmitted to the plurality of sub pixels SP through the second pad electrode PAD2, the side line SRL, and the first pad electrode PAD 1. Accordingly, a signal transmitting path from the front surface of the display panel PN to the side surface and the rear surface is formed to minimize or at least reduce an area of the non-active area NA on the front surface of the display panel PN.

Further, referring to FIG. 2B, a tiling display device TD having a large screen size may be implemented by connecting a plurality of display devices 100. At this time, as illustrated in FIG. 2A, when the tiling display device TD is implemented using a display device 100 with a minimized bezel, a seam area in which an image between the display devices 100 is not displayed is minimized so that a display quality may be improved.

For example, the plurality of sub pixels SP forms one pixel PX and a distance D 1 between an outermost pixel PX of one display device 100 and an outermost pixel PX of another display device 100 adjacent to one display device may be implemented to be equal to a distance D1 between pixels PX in one display device 100. Accordingly, the distance between pixels PX between the display devices 100 is constantly configured to minimize or at least reduce the seam area.

However, FIGS. 2A and 2B are illustrative so that the display device 100 according to the exemplary embodiment of the present disclosure may be a general display device with a bezel, but is not limited thereto.

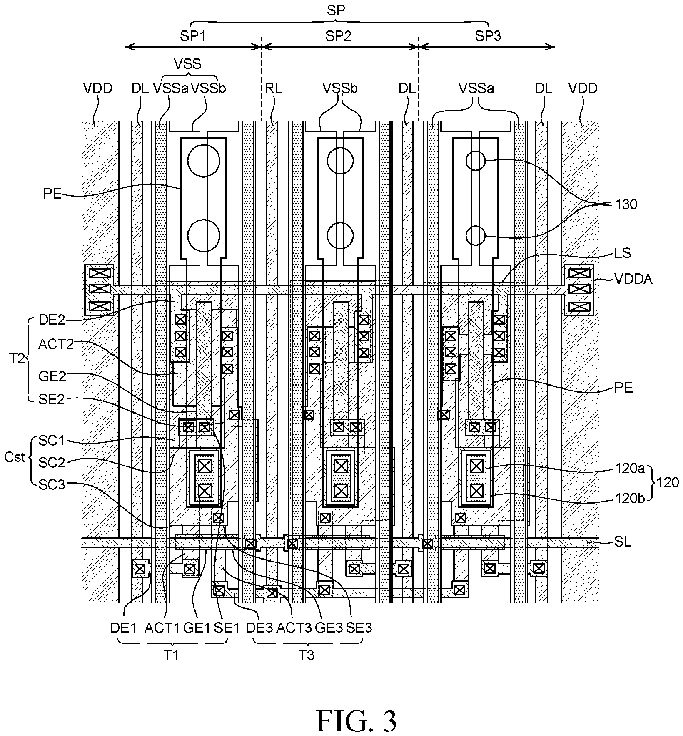

Hereinafter, a display panel PN of a display device 100 according to an exemplary embodiment of the present disclosure will be described in more detail with reference to FIGS. 3 to 7.

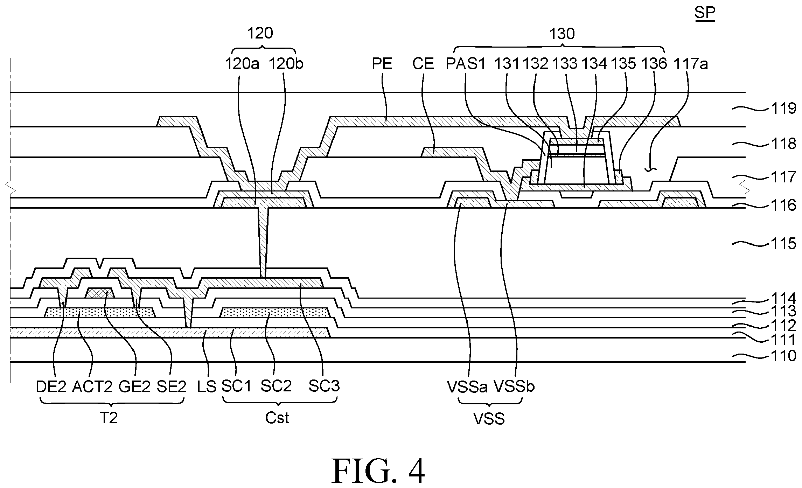

FIG. 3 is an enlarged plan view of an active area of a display device according to an exemplary embodiment of the present disclosure. FIG. 4 is a cross-sectional view of a sub pixel of a display device according to an exemplary embodiment of the present disclosure. In FIG. 3, for the convenience of description, the hatching of a clad layer VSSb, a pixel electrode PE, and a light emitting diode 130 is omitted and the contact electrode CE is not illustrated.

Referring to FIGS. 3 and 4, each of the plurality of sub pixels SP includes a first transistor T1, a second transistor T2, a third transistor T3, a storage capacitor Cst, and one or more light emitting diodes 130.

Further, the plurality of sub pixels SP may be connected to a plurality of scan lines SL, a plurality of data lines DL, a plurality of reference lines RL, a plurality of high potential power lines VDD, and a plurality of low potential power lines VSS.

The plurality of sub pixels SP include a first sub pixel SP1, a second sub pixel SP2, and a third sub pixel SP3. Each of the first sub pixel SP1, the second sub pixel SP2, and the third sub pixel SP3 includes a light emitting diode 130 and a pixel circuit to independently emit light. For example, the first sub pixel SP1 is a red sub pixel SP, the second sub pixel SP2 is a green sub pixel SP, and the third sub pixel SP3 is a blue sub pixel SP, but the exemplary embodiment is not limited thereto.

Referring to FIGS. 3 and 4, the substrate 110 is a component for supporting various components included in the display device 100 and may be formed of an insulating material. For example, the substrate 110 may be formed of glass or resin. Further, the substrate 110 may be configured to include polymer or plastics or may be formed of a material having flexibility.

A high potential power line VDD, a plurality of data lines DL, a reference line RL, a light shielding layer LS, and a first capacitor electrode SC1 are disposed on the substrate 110.

The high potential power line VDD is a wiring line which transmits a high potential power voltage to each of the plurality of sub pixels SP. The plurality of high potential power lines VDD may transmit the high potential power voltage to the second transistor T2 of each of the plurality of sub pixels SP. The high potential power line VDD may extend along a column direction between the plurality of sub pixels SP. For example, the high potential power line VDD may be disposed to extend along a column direction between the first sub pixel SP1 and the third sub pixel SP3. Further, the high potential power line VDD may transmit a high potential power voltage to each of the plurality of sub pixels SP disposed in the row direction through an auxiliary high potential power line VDDA to be described below.

The plurality of data lines DL are wiring lines which transmit the data voltage to the plurality of sub pixels SP. The plurality of data lines DL may be connected to the first transistor T1 of each of the plurality of sub pixels SP. The plurality of data lines DL may extend along a column direction between the plurality of sub pixels SP. For example, a data line DL which extends between the first sub pixel SP1 and the high potential power line VDD in the column direction in a plan view of the display device transmits a data voltage to the first sub pixel SP1. A data line DL disposed between the second sub pixel SP2 and the third sub pixel SP3 in the plan view transmits a data voltage to the second sub pixel SP2. Further, a data line DL disposed between the third sub pixel SP3 and the high potential power line VDD in the plan view may transmit a data voltage to the third sub pixel SP3.

Each reference line RL is a wiring line which transmits a reference voltage to the plurality of sub pixels SP. The reference line RL may be connected to the third transistor T3 of each of the plurality of sub pixels SP. The reference line RL may extend along a column direction between the plurality of sub pixels SP in the plan view. For example, the reference line RL may extend along a column direction between the first sub pixel SP1 and the second sub pixel SP2 in the plan view. A third drain electrode DE3 of the third transistor T3 of each of the first sub pixel SP1, the second sub pixel SP2, and the third sub pixel SP3 adjacent to the reference line RL extends in the row direction to be electrically connected to the reference line RL.

The light shielding layer LS is disposed on the substrate 110 in each of the plurality of sub pixels SP. The light shielding layer LS blocks light which is incident to the transistor from the lower portion of the substrate 110 to minimize or at least reduce a leakage current. For example, the light shielding layer LS may block light incident to a second active layer ACT2 of the second transistor T2 which is a driving transistor.

In each of the plurality of sub pixels SP, a first capacitor electrode SC1 is disposed on the substrate 110. The first capacitor electrode SC1 may form a storage capacitor Cst together with the other capacitor electrode. The first capacitor electrode SC1 may be integrally formed with the light shielding layer LS.

A buffer layer 111 is disposed on the high potential power line VDD, the plurality of data lines DL, the reference line RL, the light shielding layer LS, and the first capacitor electrode SC1. The buffer layer 111 may reduce permeation of moisture or impurities through the substrate 110. The buffer layer 111 may be configured by a single layer or a double layer of silicon oxide (SiOx) or silicon nitride (SiNx), but is not limited thereto. However, the buffer layer 111 may be omitted depending on a type of substrate 110 or a type of transistor, but is not limited thereto.

The first transistor T1 is disposed in each of the plurality of sub pixels SP on the buffer layer 111. The first transistor T1 is a transistor which transmits a data voltage to the second gate electrode GE2 of the second transistor T2. The first transistor T1 is turned on by a scan signal from the scan line SL and a data voltage from the data line DL is transmitted to the second gate electrode GE2 of the second transistor T2 through the turned-on first transistor T 1. Accordingly, the first transistor T1 may be referred to as a switching transistor.

The first transistor T1 includes a first active layer ACT1, a first gate electrode GE1, a first source electrode SE1, and a first drain electrode DE1.

The first active layer ACT1 is disposed on the buffer layer 111. The first active layer ACT1 may be formed of a semiconductor material such as an oxide semiconductor, amorphous silicon, or polysilicon, but is not limited thereto.

The gate insulating layer 112 is disposed on the first active layer ACT1. The gate insulating layer 112 is an insulating layer which insulates the first active layer ACT1 from the first gate electrode GE1 and may be configured by a single layer or a double layer of silicon oxide (SiOx) or silicon nitride (SiNx), but is not limited thereto.

The first gate electrode GE1 is disposed on the gate insulating layer 112. The first gate electrode GE1 may be electrically connected to the scan line SL. The first gate electrode GE1 may be configured by a conductive material, such as copper (Cu), aluminum (Al), molybdenum (Mo), nickel (Ni), titanium (Ti), chrome (Cr), or an alloy thereof, but is not limited thereto.

The interlayer insulating layer 113 is disposed on the first gate electrode GE1. A contact hole is formed in the interlayer insulating layer 113 to allow the first source electrode SE1 and the first drain electrode DE1 to be connected to the first active layer ACT1. The interlayer insulating layer 113 is an insulating layer which protects components below the interlayer insulating layer 113 and may be configured by a single layer or a double layer of silicon oxide (SiOx) or silicon nitride (SiNx), but is not limited thereto.

A first source electrode SE1 and a first drain electrode DE1 which are electrically connected to the first active layer ACT1 are disposed on the interlayer insulating layer 113. The first drain electrode DE1 may be electrically connected to the data line DL and the first active layer ACT1 and the first source electrode SE1 may be electrically connected to the first active layer ACT1 and the second gate electrode GE2 of the second transistor T2. The first source electrode SE1 and the first drain electrode DE1 may be configured by a conductive material, such as copper (Cu), aluminum (Al), molybdenum (Mo), nickel (Ni), titanium (Ti), chrome (Cr), or an alloy thereof, but are not limited thereto.

The second transistor T2 is disposed on the buffer layer 111 in each of the plurality of sub pixels SP. The second transistor T2 is a transistor which supplies a driving current to the light emitting diode 130. The second transistor T2 is turned on to control the driving current flowing to the light emitting diode 130. Accordingly, the second transistor T2 which controls the driving current may be referred to as a driving transistor.

The second transistor T2 includes a second active layer ACT2, a second gate electrode GE2, a second source electrode SE2, and a second drain electrode DE2.

The second active layer ACT2 is disposed on the buffer layer 111. The second active layer ACT2 may be formed of a semiconductor material such as an oxide semiconductor, amorphous silicon, or polysilicon, but is not limited thereto.

The gate insulating layer 112 is disposed on the second active layer ACT2 and the second gate electrode GE2 is disposed on the gate insulating layer 112. The second gate electrode GE2 may be electrically connected to the first source electrode SE1 of the first transistor T1. The second gate electrode GE2 may be configured by a conductive material, such as copper (Cu), aluminum (Al), molybdenum (Mo), nickel (Ni), titanium (Ti), chrome (Cr), or an alloy thereof, but is not limited thereto.

The interlayer insulating layer 113 is disposed on the second gate electrode GE2 and the second source electrode SE2 and the second drain electrode DE2 which are electrically connected to the second active layer ACT2 are disposed on the interlayer insulating layer 113. The second drain electrode DE2 may be electrically connected to the second active layer ACT2 and the high potential power line VDD and the second source electrode SE2 may be electrically connected to the second active layer ACT2 and the light emitting diode 130. The second source electrode SE2 and the second drain electrode DE2 may be configured by a conductive material, such as copper (Cu), aluminum (Al), molybdenum (Mo), nickel (Ni), titanium (Ti), chrome (Cr), or an alloy thereof, but are not limited thereto.

The third transistor T3 is disposed on the buffer layer 111 in each of the plurality of sub pixels SP. The third transistor T3 is a transistor for compensating for a threshold voltage of the second transistor T2. The third transistor T3 is connected between the second source electrode SE2 of the second transistor T2 and the reference line RL. The third transistor T3 is turned on to transmit the reference voltage to the second source electrode SE2 of the second transistor T2 to sense a threshold voltage of the second transistor T2. Accordingly, the third transistor T3 which senses a characteristic of the second transistor T2 may be referred to as a sensing transistor.

The third transistor T3 includes a third active layer ACT3, a third gate electrode GE3, a third source electrode SE3, and a third drain electrode DE3.

The third active layer ACT3 is disposed on the buffer layer 111. The third active layer ACT3 may be formed of a semiconductor material such as an oxide semiconductor, amorphous silicon, or polysilicon, but is not limited thereto.

The gate insulating layer 112 is disposed on the third active layer ACT3 and the third gate electrode GE3 is disposed on the gate insulating layer 112. The third gate electrode GE3 may be electrically connected to the scan line SL. The third gate electrode GE3 and the first gate electrode GE1 are integrally formed to simultaneously turn on or turn off the third transistor T3 and the first transistor T1. The third gate electrode GE3 may be configured by a conductive material, such as copper (Cu), aluminum (Al), molybdenum (Mo), nickel (Ni), titanium (Ti), chrome (Cr), or an alloy thereof, but is not limited thereto.

The interlayer insulating layer 113 is disposed on the third gate electrode GE3 and the third source electrode SE3 and the third drain electrode DE3 which are electrically connected to the third active layer ACT3 are disposed on the interlayer insulating layer 113. The third drain electrode DE3 is electrically connected to the third active layer ACT3 and the reference line RL and the third source electrode SE3 is electrically connected to the third active layer ACT3 and the second source electrode SE2 of the second transistor T2. The third source electrode SE3 and the third drain electrode DE3 may be configured by a conductive material, such as copper (Cu), aluminum (Al), molybdenum (Mo), nickel (Ni), titanium (Ti), chrome (Cr), or an alloy thereof, but are not limited thereto.

Next, the second capacitor electrode SC2 is disposed on the buffer layer 111. The second capacitor electrode SC2 is one of the electrodes which form the storage capacitor Cst and may be disposed to overlap the first capacitor electrode SC 1. The first capacitor electrode SC1 and the second capacitor electrode SC2 may be disposed to be spaced apart from each other with the buffer layer 111 therebetween. The second capacitor electrode SC2 is integrally formed with the first active layer ACT1 of the first transistor T1 to be electrically connected to the second gate electrode GE2.

The plurality of scan lines SL, the auxiliary high potential power line VDDA, and a third capacitor electrode SC3 are disposed on the interlayer insulating layer 113.

First, the scan line SL is a wiring line which transmits the scan signal to each of the plurality of sub pixels SP. The scan line SL may extend in the row direction while traversing the plurality of sub pixels SP. The scan line SL may be electrically connected to the first gate electrode GE1 of the first transistor T1 and the third gate electrode GE3 of the third transistor T3 of each of the plurality of sub pixels SP.

The auxiliary high potential power line VDDA is disposed on the interlayer insulting layer 113. The auxiliary high potential power line VDDA extends in the row direction to be disposed to traverse the plurality of sub pixels SP. That is the, auxiliary high potential power line VDDA overlaps the plurality of sub pixels SP in the plan view. The auxiliary high potential power line VDDA may be electrically connected to the high potential power line VDD extending in the column direction and the second drain electrode DE2 of the second transistor T2 of each of the plurality of sub pixels SP disposed along the row direction.

The third capacitor electrode SC3 is disposed on the interlayer insulating layer 113. The third capacitor electrode SC3 is an electrode which forms the storage capacitor Cst and may be disposed to overlap the first capacitor electrode SC1 and the second capacitor electrode SC2. The third capacitor electrode SC3 is integrally formed with the second source electrode SE2 of the second transistor T2 and the third source electrode SE3 to be electrically connected to the second source electrode SE2. Further, the second source electrode SE2 may be electrically connected to the first capacitor electrode SC1 through a contact hole formed in the interlayer insulating layer 113, the gate insulating layer 112, and the buffer layer 111. Therefore, the first capacitor electrode SC1 and the third capacitor electrode SC3 may be electrically connected to the second source electrode SE2 of the second transistor T2.

The storage capacitor Cst stores a potential difference between the second gate electrode GE2 and the second source electrode SE2 of the second transistor T2 while the light emitting diode 130 emits light, so that a constant current is supplied to the light emitting diode 130. The storage capacitor Cst includes the first capacitor electrode SC1, the second capacitor electrode SC2, and the third capacitor electrode SC3 to store a voltage between the second gate electrode GE2 and the second source electrode SE2 of the second transistor T2. The first capacitor electrode SC1 is formed on the substrate 110 and is electrically connected to the second source electrode SE2 and the second capacitor electrode SC2 is formed on the buffer layer 111 and is electrically connected to the second gate electrode GE2. The third capacitor electrode SC3 is formed on the interlayer insulating layer 113 and is electrically connected to the second source electrode SE2.

The first passivation layer 114 is disposed on the first transistor T 1, the second transistor T2, the third transistor T3, and the storage capacitor Cst. The first passivation layer 114 is an insulating layer which protects components below the first passivation layer 114 and may be configured by a single layer or a double layer of silicon oxide (SiOx) or silicon nitride (SiNx), but is not limited thereto.

The first planarization layer 115 is disposed on the first passivation layer 114. The first planarization layer 115 may planarize an upper portion of the substrate 110 on which the plurality of transistors and the storage capacitor Cst are disposed. The first planarization layer 115 may be configured by a single layer or a double layer, and for example, may be formed of photoresist or an acrylic-based organic material, but is not limited thereto.

In the meantime, even though it is not illustrated in the drawing, an additional passivation layer may be further disposed on the first planarization layer 115. For example, a passivation layer which is configured by a single layer or a double layer of silicon oxide (SiOx) or silicon nitride (SiNx) is formed on the first planarization layer 115 to protect configurations below the passivation layer.

Next, a connection electrode 120 is disposed on the first planarization layer 115. The connection electrode 120 is disposed in each of the plurality of sub pixels SP. The connection electrode 120 is an electrode which electrically connects the second transistor T2 and the pixel electrode PE. The connection electrode 120 may be electrically connected to the second source electrode SE2 through a contact hole formed in the first planarization layer 115 and the first passivation layer 114.

The connection electrode 120 may have a double layered structure formed by a first connection layer 120a and a second connection layer 120b. The first connection layer 120a is disposed on the first planarization layer 115 and the second connection layer 120b which covers the first connection layer 120a is disposed. In one embodiment, the second connection layer 120b is in direct contact with the first connection layer 120a. The second connection layer 120b may be disposed to enclose all a top surface and side surfaces of the first connection layer 120a. The second connection layer 120b includes a material which is more resistant to corrosion than the first connection layer 120a so that when the display device 100 is manufactured, the short defect due to the migration between the first connection layer 120a and the adjacent wiring line may be minimized or at least reduced. For example, the first connection layer 120a is formed of a conductive material, such as copper (Cu) or chrome (Cr) and the second connection layer 120b is formed of molybdenum (Mo) or titanium molybdenum (MoTi), but are not limited thereto.

A plurality of low potential power lines VSS are disposed on the first planarization layer 115. The plurality of low potential power lines VSS are wiring lines which transmit a low potential power voltage to the light emitting diode 130. The plurality of low potential power lines VSS extend in the column direction in each of the plurality of sub pixels SP. For example, one pair of low potential power lines VSS which are spaced apart from each other with a predetermined interval may be disposed in each of the first sub pixel SP1, the second sub pixel SP2, and the third sub pixel SP3.

Each of the plurality of low potential power lines VSS includes a conductive layer VSSa and a clad layer VSSb. The conductive layer VSSa is disposed on the first planarization layer 115 and the clad layer VSSb which covers all the top surface and the side surfaces of the conductive layer VSSa is disposed on the conductive layer VSSa. For example, the conductive layer VSSa is formed of a conductive material, such as copper (Cu) and chrome (Cr). Further, the clad layer VSSb is formed of a material which is more resistant to corrosion than the conductive layer VSSa, for example, molybdenum (Mo) or titanium molybdenum (MoTi), but is not limited thereto.

A second passivation layer 116 is disposed on the connection electrode 120 and the low potential power line VSS. The second passivation layer 116 is an insulating layer which protects components below the second passivation layer 116 and may be configured by a single layer or a double layer of silicon oxide (SiOx) or silicon nitride (SiNx), but is not limited thereto. Further, the second passivation layer 116 may protect the low potential power line VSS and the connection electrode 120 from a fluid WT during the self-assembly process of the light emitting diode 130, which will be described in more detail below.

The second planarization layer 117 is disposed on the second passivation layer 116. The second planarization layer 117 includes a plurality of openings 117a in which each of the plurality of light emitting diodes 130 is seated. The plurality of openings 117a may be disposed in each of the plurality of sub pixels SP. For example, the number of openings 117a is the same as the number of light emitting diodes 130 disposed in one sub pixel SP.

The plurality of openings 117a are a part in which the plurality of light emitting diodes 130 is inserted and is also referred to as pockets. The plurality of openings 117a may be formed so as to overlap the plurality of low potential power lines VSS. One opening 117a may overlap an area between one pair of low potential power lines VSS disposed to be adjacent to each other in one sub pixel SP. For example, the clad layer VSSb of one pair of low potential power lines VSS may overlap the opening 117a. The second planarization layer 117 may be configured by a single layer or a double layer, and for example, may be formed of photoresist or an acrylic-based organic material, but is not limited thereto.

Next, the plurality of light emitting diodes 130 are disposed in the plurality of openings 117a of the second planarization layer 117 on the second passivation layer 116. One or more light emitting diodes 130 are disposed in one sub pixel SP. For example, two light emitting diodes 130 may be disposed in one sub pixel SP. The light emitting diode 130 is an element which emits light by the current. The light emitting diode 130 may include a light emitting diode 130 which emits red light, green light, and blue light and may implement various color light including white by a combination thereof. Further, various color light may be implemented using the light emitting diode 130 which emits specific color light and a light conversion member which converts light from the light emitting diode 130 into another color light. The light emitting diode 130 is electrically connected between the second transistor T2 and the low potential power line VSS to be supplied with a driving current from the second transistor T2 to emit light.

At this time, the plurality of light emitting diodes 130 disposed in one sub pixel SP may be connected in parallel. That is, one electrode of each of the plurality of light emitting diodes 130 is connected to the source electrode of the second transistor T2 and the other electrode may be connected to the same low potential power line VSS.

In the meantime, the light emitting diode 130 may include a red light emitting diode, a green light emitting diode, and a blue light emitting diode. For example, the red light emitting diode may be disposed in the first sub pixel of the plurality of sub pixels SP, the green light emitting diode is disposed in the second sub pixel SP2 of the plurality of sub pixels SP, and the blue light emitting diode may be disposed in the third sub pixel SP3. However, a configuration of the light emitting diode 130 is illustrative, but is not limited thereto.

At this time, the light emitting diode 130 disposed in each of the plurality of sub pixels SP may have a different size. For example, the red light emitting diode has the largest size (e.g., a first size), the blue light emitting diode has the smallest size (e.g., a second side), and the green light emitting diode may have a size between the red light emitting diode and the blue light emitting diode (e.g., a third size). The red light emitting diode, the green light emitting diode, and the blue light emitting diode have different sizes and different luminous efficiencies so that a design of the second transistor T2 for driving the red light emitting diode, the green light emitting diode, and the blue light emitting diode may vary. For example, the second transistor T2 of the first sub pixel SP1 for driving the red light emitting diode includes a second active layer ACT2 having the largest size and the second transistor T2 of the third sub pixel SP3 for driving the blue light emitting diode may include a second active layer ACT2 having the smallest size. However, the size of the light emitting diode 130 is illustrative and all the light emitting diodes 130 may have the same size or may have different sizes, but are not limited thereto.

Further, even though in FIG. 3, for the convenience of description, it is illustrated that two light emitting diodes 130 are disposed in each of the plurality of sub pixels SP, the number of light emitting diodes 130 which are disposed in each of the plurality of sub pixels SP is not limited thereto.

The light emitting diode 130 includes a first semiconductor layer 131, an emission layer 132, a second semiconductor layer 133, a first electrode 134, a second electrode 135, a side electrode 136, and a first insulating film PAS1.

The first semiconductor layer 131 is disposed on the second passivation layer 116 and the second semiconductor layer 133 is disposed on the first semiconductor layer 131. The first semiconductor layer 131 and the second semiconductor layer 133 may be layers formed by doping n-type and p-type impurities into a specific material. For example, the first semiconductor layer 131 and the second semiconductor layer 133 may be layers formed by doping p-type and n-type impurities into a material, such as gallium nitride (GaN), indium aluminum phosphide (InAlP), or gallium arsenide (GaAs). Further, the p-type impurity may be magnesium (Mg), zinc (Zn), and beryllium (Be), and the n-type impurity may be silicon (Si), germanium (Ge), and tin (Sn), but are not limited thereto.

The emission layer 132 is disposed between the first semiconductor layer 131 and the second semiconductor layer 133. The emission layer 132 is supplied with holes and electrons from the first semiconductor layer 131 and the second semiconductor layer 133 to emit light. The emission layer 132 may be formed by a single layer or a multi-quantum well (MQW) structure, and for example, may be formed of indium gallium nitride (InGaN) or gallium nitride (GaN), but is not limited thereto.

The side electrode 136 (e.g., a third electrode) is disposed on the side surface of the first semiconductor layer 131 but not the second semiconductor layer 133. The side electrode 136 is disposed so as to correspond to (e.g., overlap) a side surface of the first semiconductor layer 131. The side electrode 136 is an electrode which induces self-assembly of the light emitting diode 130 by forming an attractive force (e.g., magnetic force) with the magnet MG during the self-assembly of the light emitting diode 130. The side electrode 136 is disposed in a lower part of the light emitting diode 130 to self-assemble the first semiconductor layer 131 of the light emitting diode 130 to face the low potential power line VSS. As shown in FIG. 4, the side electrode 136 is on a side surface of the first semiconductor layer 131 such that the side electrode 136 is between an end of the first electrode 134 and the side surface of the first semiconductor layer 131. The side electrode 136 may include a ferromagnetic material and for example, formed of nickel (Ni). Further, the side electrode 136 further includes a layer formed of a ferromagnetic material and an opaque conductive material having a high reflectance to be formed with a double-layered structure. In this case, some of light facing a side surface, among light emitted from the light emitting diode 130 is reflected from the side electrode 136 to be directed to the upper portion of the light emitting diode 130.

The first electrode 134 is disposed below the first semiconductor layer 131. The first electrode 134 is an electrode which electrically connects the light emitting diode 130 and the low potential power line VSS. The first electrode 134 may cover the entire lower part of the light emitting diode 130. The first electrode 134 may cover the lower part of the side electrode 136 from a bottom surface of the first semiconductor layer 131. The first electrode 134 may be formed of different materials depending on whether a reflection layer is provided. For example, as illustrated in the drawing, when a separate reflection layer is not formed below the light emitting diode 130, the first electrode 134 may be configured by an opaque conductive material having a high reflection efficiency, such as titanium (Ti), gold (Au), silver (Ag), copper (Cu), or an alloy thereof. That is, the first electrode 134 may function as a reflection electrode. In contrast, when the reflection layer is formed below the light emitting diode 130, the first electrode 134 may be configured by a transparent conductive material, such as indium tin oxide (ITO) or indium zinc oxide (IZO), but is not limited thereto. Therefore, light which is directed to the lower portion of the light emitting diode 130 may be reflected toward the upper portion of the light emitting diode 130 through the first electrode 134 or a separate reflection layer and the luminous efficiency may be improved.

The second electrode 135 is disposed on the top surface of the second semiconductor layer 133. The second electrode 135 is an electrode which electrically connects a pixel electrode PE to be described below and the second semiconductor layer 133. For example, the second electrode 135 is formed of a transparent conductive material, such as indium tin oxide (ITO) or indium zinc oxide (IZO), but is not limited thereto.

A first insulating film PAS1 which encloses at least a part of the first semiconductor layer 131, the emission layer 132, the second semiconductor layer 133, and the second electrode 135 is disposed. The first insulating film PAS1 is formed of an insulating material to protect the first semiconductor layer 131, the emission layer 132, and the second semiconductor layer 133. The first insulating film PAS1 may cover a side surface of the first semiconductor layer 131, a side surface of the emission layer 132, a side surface of the second semiconductor layer 133, and a part of an edge of the second electrode 135. As shown in FIG. 4, an end of the first insulating film PAS1 contacts an upper surface of the first electrode 134. A part of the second electrode 135 is exposed from the first insulating film PAS1 and the pixel electrode PE and the second electrode 135 to be formed later may be electrically connected. Further, the first insulating film PAS1 is disposed between the side electrode 136 and the first semiconductor layer 131 so that the side electrode 136 is not directly connected to the first semiconductor layer 131. The side electrode 136 may be disposed to be spaced apart from the first semiconductor layer 131 by the first insulating film PAS1. Instead, the side electrode 136 may be electrically connected to the first semiconductor layer 131 through the first electrode 134. As shown in FIG. 4, the side electrode 136 is directly connected to the first electrode 134 in one embodiment.

The contact electrode CE is disposed on the side surface of the light emitting diode 130. The contact electrode CE is an electrode for electrically connecting the light emitting diode 130 and the low potential power line VSS. The contact electrode CE may be electrically connected to the low potential power line VSS through a contact hole formed in the second passivation layer 116. Further, the contact electrode CE is disposed so as to enclose at least a part of a lower side surface of the light emitting diode 130 to be in contact with (e.g., direct contact) the side electrode 136 and the first electrode 134. Therefore, the low potential power line VSS and the light emitting diode 130 may be electrically connected through the contact electrode CE.

In the meantime, in FIG. 4, it is illustrated that only one low potential power line VSS, between one pair of low potential power lines VSS, is electrically connected to the light emitting diode 130 through the contact electrode CE. However, the contact electrode CE may be electrically connected to both pair of low potential power lines VSS, but is not limited thereto.

Next, a third planarization layer 118 is disposed on the second planarization layer 117, the light emitting diode 130, and the contact electrode CE. The third planarization layer 118 planarizes an upper portion of the substrate 110 on which the light emitting diode 130 is disposed and may fix (attach) the light emitting diode 130 onto the substrate 110. The third planarization layer 118 may be configured by a single layer or a double layer, and for example, may be formed of photoresist or an acrylic-based organic material, but is not limited thereto.

The pixel electrode CE is disposed on the third planarization layer 118. The pixel electrode PE is an electrode which electrically connects the plurality of light emitting diodes 130 and the connection electrode 120. The pixel electrode PE is electrically connected to the connection electrode 120 and the second transistor T2 through the contact hole formed in the third planarization layer 118, the second planarization layer 117 and the second passivation layer 116. Further, the pixel electrode PE may be electrically connected to the second electrode 135 of the light emitting diode 130 exposed from the third planarization layer 118. Accordingly, the second electrode 135 of the light emitting diodes 130, the connection electrode 120, and the second source electrode SE2 of the second transistor T2 may be electrically connected to each other by means of the pixel electrode PE. The pixel electrode PE is formed of a conductive material, for example, a transparent conductive material, such as indium tin oxide (ITO) or indium zinc oxide (IZO), but is not limited thereto.

A protection layer 119 is disposed on the pixel electrode PE. The protection layer 119 is a layer for protecting components below the protection layer 119, and may be configured by a single layer or a double layer of translucent epoxy, silicon oxide (SiOx) or silicon nitride (SiNx), but is not limited thereto.

In the meantime, even though it is not illustrated in the drawing, a black matrix may be further disposed on the third planarization layer 118. The black matrix is disposed between the plurality of sub pixels SP on the third planarization layer 118 to reduce color mixture between the plurality of sub pixels SP. Further, the black matrix covers a part in which the connection electrode 120 and the pixel electrode PE are connected to suppress light leakage from the portion. The black matrix may be formed of an opaque material and for example, may be formed of black resin, but is not limited thereto.

Therefore, in the display device 100 according to the exemplary embodiment of the present disclosure, the side electrode 136 is formed on the side surface of the first semiconductor layer 131 to improve the luminous efficiency of the light emitting diode 130. If the side electrode 136 is formed below the light emitting diode 130, the side electrode configured by nickel having a low light reflection efficiency absorbs some of light directed to the lower portion of the light emitting diode 130 to reduce light which is reflected to the upper portion of the light emitting diode 130. Therefore, instead of the side electrode 136 having a low light reflection efficiency, another electrode having a high reflection characteristic is disposed below the first semiconductor layer 131 to improve the luminous efficiency of the light emitting diode 130. Accordingly, the side electrode 136 is partially formed on a lower side surface of the light emitting diode 130 to align the direction of the light emitting diode 130 during the self-assembly process. In this case, a separate reflection layer or a reflection electrode is formed below the light emitting diode 130 to improve the luminous efficiency of the light emitting diode 130.

In the meantime, in the display device 100 according to the exemplary embodiment of the present disclosure, the plurality of light emitting diodes 130 are self-assembled on the substrate 110 using a plurality of low potential power lines VSS. The plurality of light emitting diodes 130 are dielectrically polarized by the electric field to have a polarity. Therefore, the plurality of light emitting diodes 130 may move or be fixed to a specific direction by an electric field and the plurality of light emitting diodes 130 may be easily transferred onto the display device 100 using this characteristic.

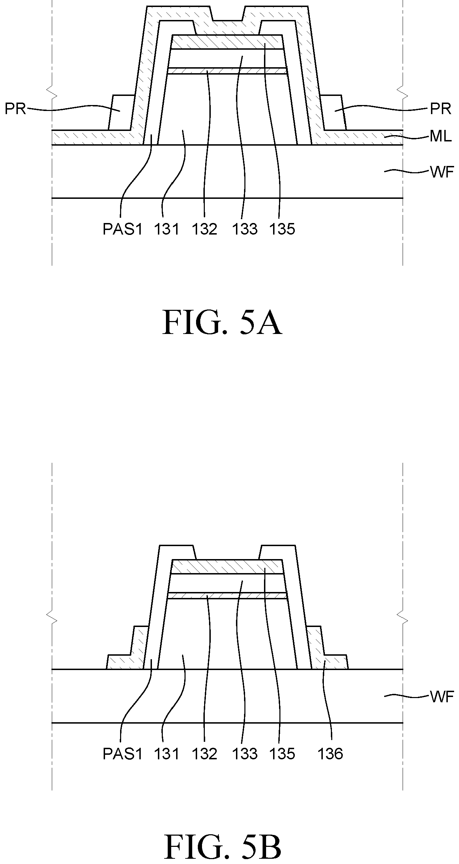

Hereinafter, a method of manufacturing a display device 100 according to an exemplary embodiment of the present disclosure will be described with reference to FIGS. 5A to 6E.

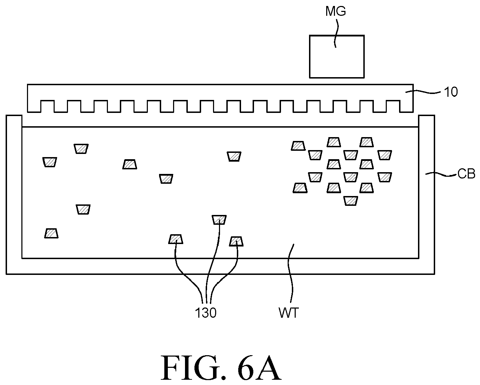

FIGS. 5A to 5D are cross-sectional views for explaining a method of manufacturing a light emitting diode of a display device according to an exemplary embodiment of the present disclosure. FIGS. 6A to 6E are cross-sectional views for explaining a method of manufacturing a display device according to an exemplary embodiment of the present disclosure using a self-assembly process.

Referring to FIGS. 5A to 5D, a light emitting diode 130 to be self-assembled in the display device 100 may be formed on a wafer WF.

First, referring to FIG. 5A, a first semiconductor layer 131, an emission layer 132, and a second semiconductor layer 133 of the light emitting diode 130 are formed on the wafer WF.

The wafer WF is a substrate for growing a plurality of light emitting diodes 130 and may be formed of various materials depending on a material which configures the plurality of light emitting diodes 130. For example, the wafer WF may be formed of sapphire, gallium nitride (GaN), silicon (Si), or silicon carbide (SiC), but is not limited thereto.

An epitaxial layer is grown on the wafer WF. The epitaxial layer is a layer which is formed of a semiconductor material configuring the plurality of light emitting diodes 130. Semiconductor layers which form the first semiconductor layer 131, the emission layer 132, and the second semiconductor layer 133 may be sequentially formed by growing the semiconductor crystal on the wafer WF. Further, a conductive layer for forming the second electrode 135 may be formed on the epitaxial layer.

Next, the epitaxial layer and the conductive layer are patterned into a plurality of pieces to form the first semiconductor layer 131, the emission layer 132, the second semiconductor layer 133, and the second electrode 135 of each of the plurality of light emitting diodes 130.

Further, a first insulating film PAS1 which covers the first semiconductor layer 131, the emission layer 132, the second semiconductor layer 133, and the second electrode 135 is disposed. At this time, a part of the first insulating film PAS1 which covers the second electrode 135 is patterned to expose the second electrode 135 from the first insulating film PAS1.

Referring to FIGS. 5A and 5B together, a metal ML is formed on a front surface of the wafer WF on which the first semiconductor layer 131, the emission layer 132, the second semiconductor layer 133, the second electrode 135, and the first insulating film PAS1 are formed. A photoresist pattern PR is formed to be adjacent to a lower side surface of the first semiconductor layer 131. Therefore, a remaining part of the metal layer ML excluding a part of the metal layer ML corresponding to the photoresist pattern PR is etched to form a side electrode 136. In this case, the side electrode 136 may be formed by a part which is in contact with a side surface of the first insulating film PAS1 and a part which protrudes from the part in contact with the side surface to be in contact with a top surface of the wafer WF. That is, the side electrode 136 may be formed in an L shape. A part of the side electrode 136 which is in contact with the top surface of the wafer WF is a remaining film formed by the processing process and may be removed by a subsequent process.

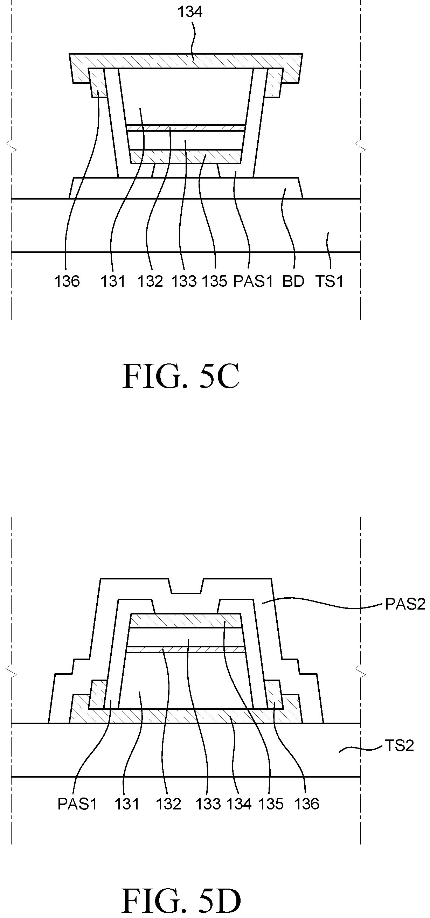

Next, referring to FIG. 5C, the light emitting diode 130 is transferred to the first temporary substrate TS1 on which a bonding material BD is formed to dispose the light emitting diode 130 on the first temporary substrate TS1 such that a lower side of the light emitting diode 130 faces upward. The light emitting diode 130 is separated from the wafer WF to be temporally attached to the bonding material BD on the first temporary substrate TS1. Therefore, the wafer WF and the light emitting diode 130 are separated and one surface of the first semiconductor layer 131 of the light emitting diode 130 may be exposed to the outside.

Next, a protruding part of the side electrode 136 which is in contact with the top surface of the wafer WF, that is, the remaining film may be partially etched. In this case, only a part of the L-shaped side electrode 136 which is in contact with the first insulating film PAS 1 may remain. A part of the side electrode 136 which protrudes without being in contact with the first insulating film PAS1 is removed so that the protruding part of the side electrode 136 does not interrupt the light emitting diode 130 from being seated in the opening 117a. Further, during the self-assembly process of the light emitting diode 130 using a magnet MG and an electric field, a deviation in an assembly rate of the plurality of light emitting diodes 130 may occur due to the remaining film of the side electrode 136. Therefore, the remaining film of the side electrode 136 is removed so that only a part of the side electrode 136 which is in contact with the first insulating film PAS1 remains to reduce the deviation in an assembly rate and the light emitting diode 130 may be controlled to be easily seated in the opening 117a.

Further, the first electrode 134 is formed on one surface (e.g., a lower surface) of the first semiconductor layer 131. At this time, when the first electrode 134 is formed of a transparent conductive material having a high step coverage, the first electrode 134 may be formed to cover the side portion of the light emitting diode 130. For example, the first electrode 134 may be formed to cover a part of the side surface of the side electrode 136 while covering one surface of the first semiconductor layer 131 and one surface of the side electrode 136. However, the first electrode 134 may be formed on one surface of the side electrode 136 and one surface of the first semiconductor layer 131, but is not limited thereto.

Referring to FIG. 5D, the light emitting diode 130 may be transferred from the first temporary substrate TS1 to a second temporary substrate TS2. Therefore, the light emitting diode 130 may be disposed such that the second electrode 135 faces upward.

Further, a second insulating film PAS2 which covers the light emitting diode 130 is formed. The second insulating film PAS2 may cover an upper portion and a side portion of the light emitting diode 130. The second insulating film PAS2 protects the light emitting diode 130 while self-assembling the light emitting diode 130 in the fluid WT and suppresses the light emitting diode 130 from being adhered to another light emitting diode 130 or being adhered to a place, other than the opening 117a on the substrate 110. The semiconductor layer of the plurality of light emitting diodes 130 is a material having a polarity and is adhered to another place if the second insulating film PAS2 is not provided. Therefore, the second insulating film PAS2 is formed to suppress the plurality of light emitting diodes 130 from being adhered to each other to be configured as a lump or adhering an area other than the opening 117a and a self-assembly yield of the light emitting diode 130 may be improved.

Next, referring to FIG. 6A, the light emitting diode 130 in which the second insulating film PAS2 is formed is input into a chamber CB filled with a fluid WT. The fluid WT may include water and a top of the chamber CB filled with fluid is open.

Next, a mother substrate 10 may be located on the chamber CB filled with the light emitting diode 130. The mother substrate 10 is a substrate 110 in which a plurality of substrates 110 which form the display device 100 is connected and the mother substrate 10 is cut to be divided into the plurality of substrates 110. When the plurality of light emitting diodes 130 are self-assembled, the mother substrate 10 on which the plurality of low potential power lines VSS, the second passivation layer 116, and the second planarization layer 117 are formed may be used.

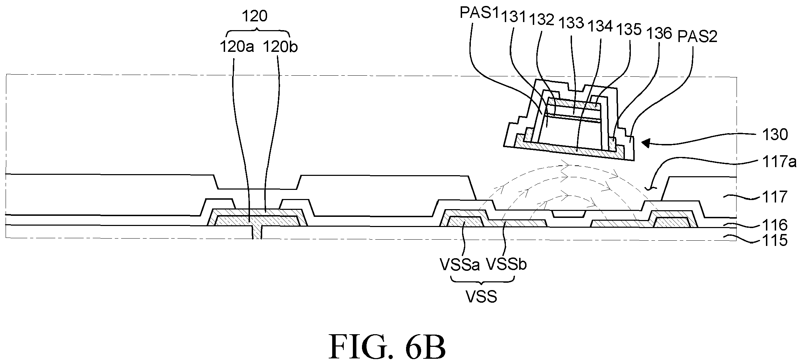

Specifically, referring to FIG. 6B, the buffer layer 111, the gate insulating layer 112, the interlayer insulating layer 113, the first passivation layer 114, the first planarization layer 115, the plurality of connection electrodes 120, and the plurality of low potential power lines VSS, the second passivation layer 116, and the second planarization layer 117 may be sequentially formed on the substrate 110 together with the pixel circuit. At this time, a contact hole which exposes the low potential power line VSS is not formed in the second passivation layer 116 and the opening 117a in which the light emitting diode 130 is seated may be formed in the second planarization layer 117. The second passivation layer 116 is disposed to cover the entire low potential power line VSS and may protect the low potential power line VSS so as not to be damaged by the fluid WT.

The plurality of low potential power lines VSS are used as an assembly line and an assembly electrode to self-assemble the light emitting diode 130 during the manufacturing process of the display device 100 and may be used as a low potential power line VSS after completing the manufacturing process of the display device 100. During the manufacturing process of the display device 100, different voltages are applied to two adjacent low potential power lines VSS and after completing the manufacturing process of the display device 100, a same low potential power voltage may be applied to two adjacent low potential power lines VSS.

Next, the mother substrate 10 is put into the chamber CB such that the second planarization layer 117 of the mother substrate 10 faces the fluid WT and the magnet MG is located on the rear surface of the mother substrate 10. The light emitting diodes 130 sinking on the bottom of the chamber CB or floating may move toward the assembling substrate 110 by a magnetic force of the magnet MG. That is, a magnet MG is used to move the light emitting diodes 130 to the assembling substrate 110.

At this time, the light emitting diode 130 may include a conductive material which reacts the magnet MG to be moved by the magnetic field. For example, the side electrode 136 of the light emitting diode 130 includes a ferromagnetic material, such as nickel, iron, or cobalt to align the direction of the light emitting diode 130 which is directed to the magnet MG. Specifically, the side electrode 136 is disposed in a lower part of the light emitting diode 130 to align the lower part of the light emitting diode 130 to be directed to the mother substrate 10. Therefore, the light emitting diode 130 may primarily move to the mother substrate 10 using the magnet MG due to the magnetic attraction between the magnet MG and the side electrode 136 of the light emitting diode 130.

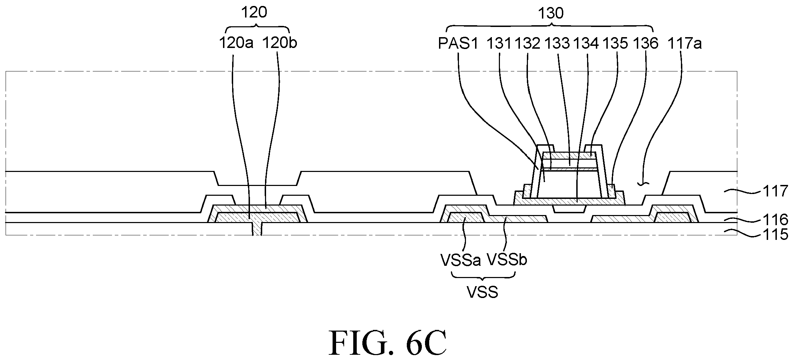

Next, referring to FIGS. 6B and 6C together, an AC voltage is applied to the plurality of low potential power lines VSS to form an electric field. Different voltages may be applied to one pair of low potential power lines VSS which are adjacent to each other. Therefore, an electric field may be formed between one pair of low potential power lines VSS which are adjacent to each other.

The light emitting diode 130 is dielectrically polarized by the electric field to have a polarity. Further, the dielectrically polarized light emitting diode 130 may move or may be fixed to a specific direction by dielectrophoresis (DEP), that is, an electric field. Accordingly, the plurality of light emitting diodes 130 are self-assembled on the low potential power line VSS using dielectrophoresis.

Next, referring to FIG. 6C, after self-assembling the light emitting diode 130 in the opening 117a of the second planarization layer 117, the second insulating film PAS2 may be removed. The second insulating film PAS2 is removed to expose side surfaces of the side electrode 136 and the first electrode 134.

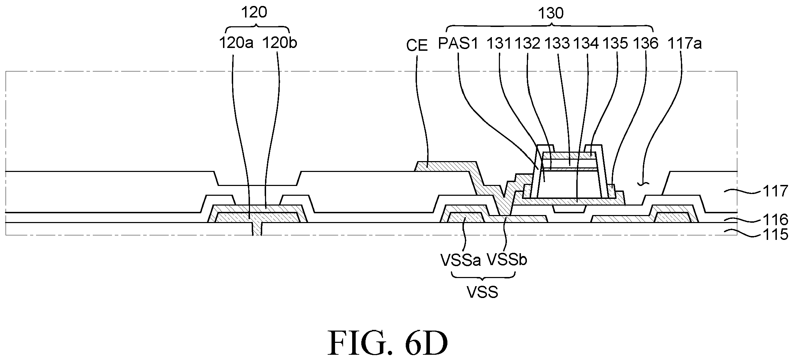

Referring to FIG. 6D, a contact hole is formed in the second passivation layer 116 to expose the clad layer VSSb of the low potential power line VSS and the connection electrode 120 is formed. In this case, a contact hole may be formed in the second passivation layer 116 using a photoresist pattern which partially covers the opening 117a in which the light emitting diode 130 is disposed. For example, the photoresist pattern is formed to cover an upper portion of the light emitting diode 130 and a part of the side surface of the light emitting diode 130 and a side surface of the light emitting diode 130 and a top surface of the second passivation layer 116 which is adjacent to one side surface may be exposed from the photoresist pattern. Further, a part of the second passivation layer 116 which is exposed from the photoresist pattern is etched to form a contact hole.

Further, a contact hole of the second passivation layer 116 and a contact electrode CE which covers a side surface of the light emitting diode 130 are formed to electrically connect the low potential power line VSS and the first semiconductor layer 131 of the light emitting diode 130, the side electrode 136, and the first electrode 134. That is, the contact electrode CE and the light emitting diode 130 may make side-contact through the side electrode 136.

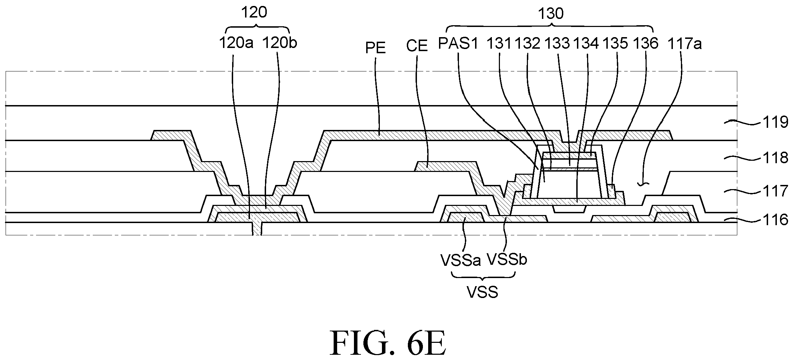

Next, referring to FIG. 6E, the third planarization layer 118 is formed on the front surface of the substrate 110 and a contact hole is formed in the third planarization layer 118 and the second planarization layer 117 to expose the connection electrode 120. Further, a contact hole may be formed in the third planarization layer 118 to expose the second electrode 135 of the light emitting diode 130.

Next, the pixel electrode PE is formed on the third planarization layer 118 to electrically connect the light emitting diode 130 and the connection electrode 120. Finally, the protection layer 119 is formed on the pixel electrode PE to manufacture the display device 100.

In the meantime, the side electrode 136 for the contact with the contact electrode CE is formed on the first insulating film PAS1 to protect the light emitting diode 130 during an etching process. For example, when the side electrode 136 is formed to be in direct contact with the side surface of the first semiconductor layer 131 and the first insulating film PAS 1 is formed so as to cover both the side electrode 136 and the first semiconductor layer 131, the light emitting diode 130 may be damaged during the subsequent process. For example, after self-assembling the light emitting diode 130, the first insulating film PAS1 needs to be removed to connect the side electrode 136 and the contact electrode CE. During the process of removing the first insulating film PAS1, a part of the first semiconductor layer 131, the emission layer 132, and the second semiconductor layer 133 may be damaged. Further, due to the process margin, it is difficult to partially etch only the first insulating film PAS1 which covers the side electrode 136 so that the first insulating film PAS1 needs to be entirely removed, which inevitably causes the damage of the light emitting diode 130.

Therefore, in the manufacturing method of the display device 100 according to the exemplary embodiment of the present disclosure, the first insulating film PAS1 which protects the first semiconductor layer 131, the emission layer 132, and the second semiconductor layer 133 is formed. The side electrode 136 and the second insulating film PAS2 are formed on the first insulating film PAS 1. In order to connect the side electrode 136 and the contact electrode CE, only the second insulating film PAS2 may be removed so that there is no need to remove the first insulating film PAS 1. Therefore, the first insulating film PAS1 remains without being removed to protect the first semiconductor layer 131, the emission layer 132, and the second semiconductor layer 133. Further, during the manufacturing process, the second insulating film PAS2 is formed to protect the light emitting diode 130 from the fluid WT or suppress the light emitting diode 130 from being adhered to the other configuration. Further, the side electrode 136 and the first semiconductor layer 131 are separated by the first insulating film PAS1, but the first electrode 134 which is in contact with one surfaces of the side electrode 136 and the first semiconductor layer 131 at the same time is formed to electrically connect the side electrode 136 and the first semiconductor layer 131. Accordingly, in the manufacturing method of the display device 100 according to the exemplary embodiment of the present disclosure, the side electrode 136 is formed on the first insulating film PAS 1. Therefore, the damage of the first semiconductor layer 131, the emission layer 132, and the second semiconductor layer 133 during the connection process of the side electrode 136 and the connect electrode CE may be suppressed.

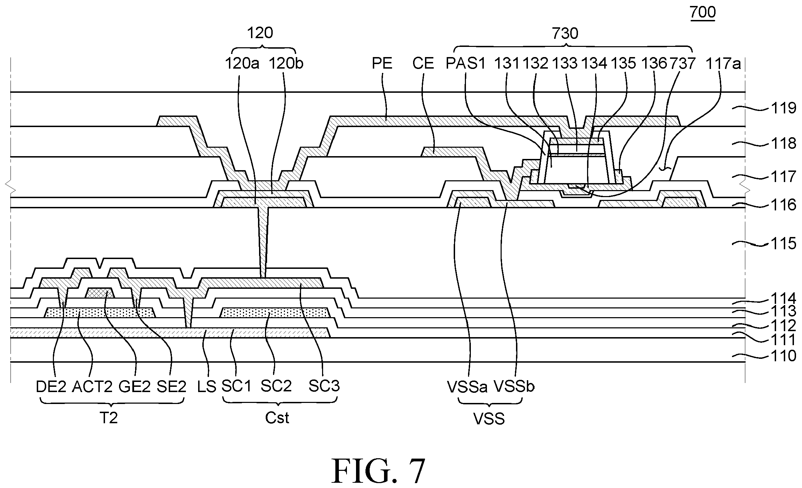

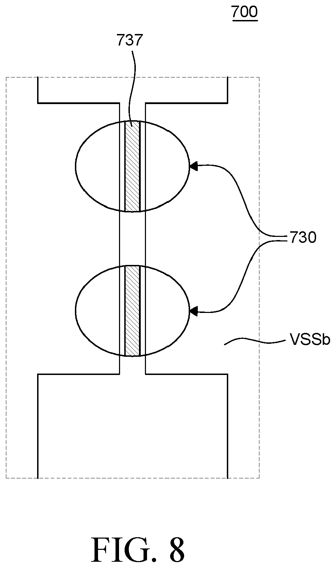

FIG. 7 is a cross-sectional view of a display device according to an exemplary embodiment of the present disclosure. FIG. 8 is an enlarged plan view of a sub pixel of a display device according to an exemplary embodiment of the present disclosure. In FIG. 8, only an ohmic contact electrode 737 of a light emitting diode 730 and a clad layer VSSb of a low potential power line VSS are illustrated. The only difference between a display device 700 of FIGS. 7 and 8 and the display device 100 of FIGS. 1 to 4 is a light emitting diode 730, but other configurations are substantially the same, so that a redundant description will be omitted.

Referring to FIGS. 7 and 8, the light emitting diode 730 includes a first semiconductor layer 131, an emission layer 132, a second semiconductor layer 133, a first electrode 134, a second electrode 135, a side electrode 136, and an ohmic contact electrode 737 (e.g., a fourth electrode).

The ohmic contact electrode 737 is disposed between a first portion of the first electrode 134 and a first portion of the first semiconductor layer 131 without being between a second portion of the first electrode 134 and a second portion of the first semiconductor layer 131 in a cross-section view of the display device. As shown in FIG. 7, remaining portions of the first semiconductor layer 131 that are not in contact with the ohmic contact electrode 737 are in contact with the first electrode 134. The ohmic contact electrode 737 may be disposed so as to overlap an area between one pair of low potential power lines VSS. That is, the ohmic contact electrode 737 is between the pair of low potential power lines VSS in the cross-section view. A bottom surface of the first semiconductor layer 131 may be configured by a first part which is in contact with the first electrode 134 and a second part which is in contact with the ohmic contact electrode 737. The ohmic contact electrode 737 is formed in a part of the bottom surface of the first semiconductor layer 131 to minimize or reduce the influence of the ohmic contact electrode 737 during the self-assembly process. The ohmic contact electrode 737 may be disposed to be spaced apart from an area in which the first electrode 134 and the second passivation layer 116 are in contact with each other. The ohmic contact electrode 737 is disposed so as to overlap a groove formed in the area between one pair of low potential power lines VSS. Therefore, when the self-assembly is performed by minimizing the interference of the ohmic contact electrode 737 and the second passivation layer 116, the light emitting diode 730 may be easily seated on the second passivation layer 116 of the opening 117a.

A contact resistance between the ohmic contact electrode 737 and the first semiconductor layer 131 is low so that the current may be easily injected to the first semiconductor layer 131 through the ohmic contact electrode 737. The ohmic contact electrode 737 is formed of a conductive material, such as chrome (Cr) or nickel (Ni), and is configured by a single layer or a double layer, but is not limited thereto. For example, the ohmic contact electrode 737 may be configured by a single layer of chrome or a double layer of chrome and nickel.

In the meantime, the ohmic contact electrode 737 which is formed of a material, such as chrome has a low light reflection efficiency. If only the ohmic contact electrode 737 is disposed below the first semiconductor layer 131, light toward the lower portion of the first semiconductor layer 131 is not reflected from the ohmic contact electrode 737, but partially absorbed so that the luminous efficiency of the light emitting diode 730 may be lowered. Therefore, the ohmic contact electrode 737 is disposed below the first semiconductor layer 131 with a minimum size and the first electrode 134 which is formed of a conductive material having a high reflectance is disposed below the ohmic contact electrode 737 to improve the light extraction efficiency.

In the display device 700 according to another exemplary embodiment of the present disclosure, the ohmic contact electrode 737 is formed between the first electrode 134 and the first semiconductor layer 131 of the light emitting diode 730 to lower the resistance. The ohmic contact electrode 737 is partially formed so as to correspond to an area between one pair of low potential power lines VSS to minimize or at least reduce the lowering of the luminous efficiency by the ohmic contact electrode 737 while improving the resistance.

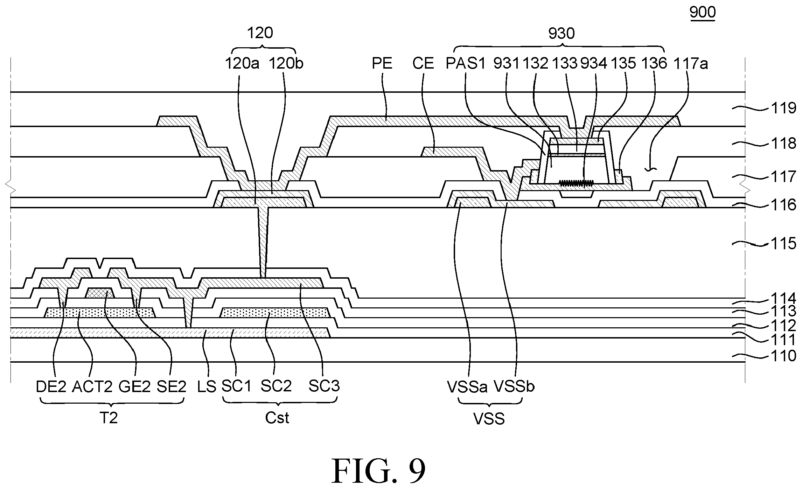

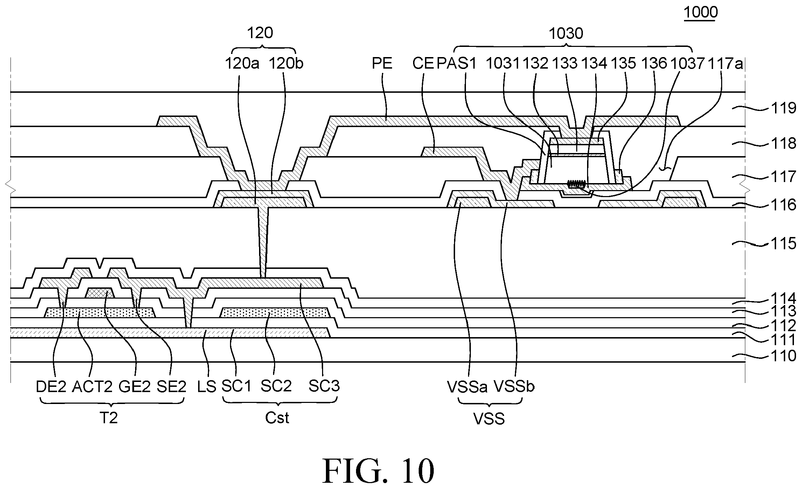

FIG. 9 is a cross-sectional view of a display device according to still another exemplary embodiment of the present disclosure. FIG. 10 is a cross-sectional view of a display device according to still another exemplary embodiment of the present disclosure. A first semiconductor layer 931 and a first electrode 934 of a display device 900 of FIG. 9 are different from those of the display device 100 of FIGS. 1 to 4 and a first semiconductor layer 1031 and an ohmic contact electrode 1037 of a display device 1000 of FIG. 10 are different from those of the display device 700 of FIGS. 7 to 8. However, the other configurations are substantially the same so that a redundant description will be omitted.

Referring to FIG. 9, an irregularity structure 901 is formed on a bonding surface between the first semiconductor layer 931 and the first electrode 934. An irregularity structure 801 may be formed on a part of the bottom surface of the first semiconductor layer 931, and accordingly, an irregularity structure may also be formed on the first electrode 934 covering the irregularity structure 901 of the first semiconductor layer 931. In one embodiment, the irregularity structure 901 is an irregularity in the bottom surface of the first semiconductor layer 931. The bottom surface of the first semiconductor layer 931 is substantially flat except for at the irregularity structure 901 that includes a jagged surface at the portion of the bottom surface of the first semiconductor layer 931 that corresponds to the irregularity structure 901. The irregularity structure 901 overlaps an area between one pair of low potential power lines VSS and may be disposed to be spaced apart from the contact area of the first electrode 934 and the second passivation layer 116. Light which is directed to the lower portion of the light emitting diode 930 is reflected from the irregularity structure between the first semiconductor layer 931 and the first electrode 934 due to the shape of the irregularity structure to be easily extracted to the outside of the display device 900.

Referring to FIG. 10, when the ohmic contact electrode 1037 is formed in the light emitting diode 1030, the irregularity structure 1001 may be formed on the bonding surface of the ohmic contact electrode 1037 and the first semiconductor layer 1031. That is, the irregularity structure 1001 is located where the ohmic contact electrode 1037 and the first semiconductor layer 1031 contact each other. The irregularity structure 1001 is formed in a part of the bottom surface of the first semiconductor layer 1031 which is in contact with the ohmic contact electrode 1037 and an irregularity structure 1001 may be formed on a surface of the ohmic contact electrode 1037 which is in contact with the first semiconductor layer 1031. In this case, the irregularity structure 1001 disposed so as to correspond to the ohmic contact electrode 1037 is disposed so as to overlap an area between one pair of low potential power lines VSS.

Accordingly, in the display devices 900 and 1000 according to still another exemplary embodiments of the present disclosure, the irregularity structure 901, 1001 is formed below the light emitting diodes 930 and 1030 to improve the light extraction efficiency. The irregularity structure may be disposed so as to overlap an area between one pair of low potential power lines VSS. In the irregularity structure, the light traveling to the bottom of the light emitting diodes 930 and 1030 is reflected to improve the light extraction efficiency. The irregularity structure is spaced apart from an area in which the light emitting didoes 930 and 1030 and the second passivation layer 116 are in contact to improve the light extraction efficiency without lowering the adhesive strength of the light emitting diodes 930 and 1030. The irregularity structure may partially be formed on the bottom surfaces of the first semiconductor layers 931 and 1031. For example, referring to FIG. 9, the irregularity structure 901 may be formed on the bonding surface of the first electrode 934 and the first semiconductor layer 931. As another example, referring to FIG. 10, the irregularity structure 1001 may be formed on the bonding surface of the ohmic contact electrode 1037 and the first semiconductor layer 1031. Accordingly, in the display devices 900 and 1000 according to still another exemplary embodiment of the present disclosure, the irregularity structure is partially formed on bottom surfaces of the first semiconductor layers 931 and 1031 of the light emitting diodes 930 and 1030 to improve the luminance of the display device and reduce the power consumption.

The exemplary embodiments of the present disclosure can also be described as follows:
According to an aspect of the present disclosure, a display device includes a substrate in which a plurality of sub pixels is defined, one pair of low potential power lines which is disposed in each of the plurality of sub pixels and is spaced apart from each other, and a plurality of light emitting diodes which is disposed in each of the plurality of sub pixels and overlaps an area between the pair of low potential power lines. Each of the plurality of light emitting diodes includes a first semiconductor layer, an emission layer on the first semiconductor layer, a second semiconductor layer on the emission layer, a first insulating film which encloses side surfaces of the first semiconductor layer, the emission layer, and the second semiconductor layer, a side electrode which is disposed on the first insulating film so as to correspond to a side surface of the first semiconductor layer, and a first electrode which is in contact with a bottom surface of the first semiconductor layer and a lower part of the side electrode.

The first electrode and the side electrode may be formed of different materials.

The side electrode may be formed of a ferromagnetic material.

The first electrode may be a reflection electrode.

The display device may further include a reflection layer disposed below the plurality of light emitting diodes. The first electrode may be formed of a transparent conductive material.

The side electrode may be disposed to be spaced apart from the first semiconductor layer by the first insulating film and the side electrode may be electrically connected to the first semiconductor layer by means of the first electrode.

Each of the plurality of light emitting diodes may further include a second electrode disposed on the second semiconductor layer, and the first insulating film covers an edge of the second electrode.

The display device may further include an ohmic contact electrode disposed between the first electrode and the first semiconductor layer. The ohmic contact electrode may overlap an area between the pair of low potential power lines.

A bottom surface of the first semiconductor layer may be formed of a part which is in contact with the first electrode and a part which is in contact with the ohmic contact electrode.

A bonding surface of the ohmic contact electrode and the first semiconductor layer may be formed with an irregularity structure.

A part of a bonding surface of the first electrode and the first semiconductor layer which corresponds to an area between the pair of low potential power lines may be formed with an irregularity structure.

According to an aspect of the present disclosure, a method of manufacturing a display device includes inputting a substrate in which one pair of low potential power lines disposed to be spaced apart from each other and a plurality of light emitting diodes into a chamber in which a fluid is formed, moving the plurality of light emitting diodes to the substrate using a magnet, and self-assembling the plurality of light emitting diodes on the substrate by forming an electric field between the pair of low potential power lines. The plurality of light emitting diodes includes a first semiconductor layer, an emission layer on the first semiconductor layer, a second semiconductor layer on the emission layer, a first insulating film which encloses side surfaces of the first semiconductor layer, the emission layer, and the second semiconductor layer, a side electrode which is disposed on the first insulating film so as to correspond to a side surface of the first semiconductor layer, and a second insulating film which covers the side electrode and the first insulating film.

The side electrode may be formed of a ferromagnetic material so that the plurality of light emitting diodes is configured to be moved to the magnet by the side electrode.

The method of manufacturing a display device may further include removing the second insulating film after self-assembling the plurality of light emitting diodes on the pair of low potential power lines, and forming a contact electrode which electrically connects the pair of low potential power lines and the side electrode.

A passivation layer may be further disposed between the pair of low potential power lines and the plurality of light emitting diodes and the contact electrode may be connected to at least one of the pair of low potential power lines through a contact hole formed in the passivation layer.

Although the exemplary embodiments of the present disclosure have been described in detail with reference to the accompanying drawings, the present disclosure is not limited thereto and may be embodied in many different forms without departing from the technical concept of the present disclosure. Therefore, the exemplary embodiments of the present disclosure are provided for illustrative purposes only but not intended to limit the technical concept of the present disclosure. The scope of the technical concept of the present disclosure is not limited thereto. Therefore, it should be understood that the above-described exemplary embodiments are illustrative in all aspects and do not limit the present disclosure. All the technical concepts in the equivalent scope of the present disclosure should be construed as falling within the scope of the present disclosure.

## Claims

1. A display device, comprising:
a substrate (100) and a plurality of sub pixels (SP); and
a pair of low potential power lines (VSSa, VSSb), the low potential power lines of the pair (VSSa, VSSb) being spaced apart from each other,
wherein at least one sub pixel (SP) of the plurality of sub pixels (SP) includes a light emitting diode (130) overlapping an area between the pair of low potential power lines (VSSa, VSSb),
wherein the light emitting diode (130) includes:
a first semiconductor layer (131);
an emission layer (132) disposed on the first semiconductor layer (131);
a second semiconductor layer (133) disposed on the emission layer (132);
a first insulating film (PAS1) that encloses a side surface of the first semiconductor layer (131), a side surface of the emission layer (132), and a side surface of the second semiconductor layer (133);
a side electrode (136) disposed on the first insulating film (PAS1) and overlapping the side surface of the first semiconductor layer (131); and
a first electrode (134) that is in contact with a bottom surface of the first semiconductor layer (131) and a lower part of the side electrode (136).

2. The display device according to claim 1, wherein the first electrode (134) and the side electrode (136) include different materials.

3. The display device according to any one of the preceding claims, wherein the side electrode (136) includes a ferromagnetic material.

4. The display device according to any one of the preceding claims, wherein the first electrode (134) is configured to reflect more light than the side electrode (136).

5. The display device according to any one of claims 1 to 3, further comprising:
a reflection layer disposed below the light emitting diode (130),
wherein the first electrode (134) includes a transparent conductive material.

6. The display device according to any one of the preceding claims, wherein the first insulating film (PAS1) is disposed between the side electrode (136) and the first semiconductor layer (131), and
wherein the side electrode (136) is electrically connected to the first semiconductor layer (131) via the first electrode (134).

7. The display device according to any one of the preceding claims, wherein the light emitting diode (130) further comprises a second electrode (135) on the second semiconductor layer (133), and the first insulating film (PAS1) covers an edge of the second electrode (135).

8. The display device according to any one of the preceding claims, further comprising:
an ohmic contact electrode (737) between a portion of the first electrode (134) and a portion of the first semiconductor layer (131),
wherein the ohmic contact electrode (737) overlaps an area between the pair of low potential power lines (VSSa, VSSb).

9. The display device according to claim 8, wherein the bottom surface of the first semiconductor layer (131) includes a first part that is in contact with the first electrode (134) and a second part that is in contact with the ohmic contact electrode (737).

10. The display device according to claim 8 or 9, wherein the bottom surface of the first semiconductor layer (134) includes an irregularity structure (934) at a location where the ohmic contact electrode (737) and the first semiconductor layer (131) contact each other, the irregularity structure comprising (934) a jagged surface.

11. The display device according to any one of the preceding claims, wherein the bottom surface of the first semiconductor layer includes an irregularity structure (934) at a location that overlaps an area between the pair of low potential power lines (VSSa, VSSb), the irregularity structure (934) comprising a jagged surface.

12. A method of manufacturing a display device, comprising:
inputting a substrate (10) into a chamber (CB) that includes a fluid (WT) and a plurality of light emitting diodes (130), the substrate (10) comprising a pair of low potential power lines (VSSa, VSSb) that are spaced apart from each other;
moving the plurality of light emitting diodes (130) to the substrate (10) using a magnet (MG); and
applying a voltage to the pair of low potential power lines (VSSa, VSSb) such that an electric field between the pair of low potential power lines (VSSa, VSSb) is formed and the plurality of light emitting diodes (130) self-assemble on the substrate (10) between the pair of low potential power lines (VSSa, VSSb) responsive to the electric field,
wherein each of the plurality of light emitting diodes (130) includes:
a first semiconductor layer (131);
an emission layer (132) disposed on the first semiconductor layer (131);
a second semiconductor layer (133) disposed on the emission layer (132);
a first insulating film (PAS1) that encloses a side surface of the first semiconductor layer (131), a side surface of the emission layer (132), and a side surface of the second semiconductor layer (133);
a side electrode (136) disposed on the first insulating film (PAS1) and overlapping the side surface of the first semiconductor layer (131); and
a second insulating film (PAS2) that covers the side electrode (136) and the first insulating film (131).

13. The method of manufacturing a display device according to claim 12, wherein the side electrode (136) includes a ferromagnetic material and the plurality of light emitting diodes (130) are moved to the substrate (10) responsive to a magnetic attraction between the magnet (MG) and the side electrode (136) of each of the plurality of light emitting diodes.

14. The method of manufacturing a display device according to claim 12 or 13, further comprising:
removing the second insulating film (PAS2) of each of the plurality of light emitting diodes (130) after the plurality of light emitting diodes (130) are self-assembled between the pair of low potential power lines; and
forming a contact electrode (CE) that electrically connects the pair of low potential power lines and the side electrode of each of the plurality of light emitting diodes.

15. The method of manufacturing a display device according to claim 14, further comprising:
disposing a passivation layer (116) between the pair of low potential power lines and the plurality of light emitting diodes;
forming a contact hole in the passivation layer; and
connecting the contact electrode to at least one of the pair of low potential power lines through the contact hole formed in the passivation layer.
